# EUROPÄISCHE PATENTSCHRIFT

(11) **EP 0 618 680 B1**
(45) Veröffentlichungstag und Bekanntmachung des Hinweises auf die Patenterteilung: **02.10.1996**
(21) Anmeldenummer: 93810865.1
(22) Anmeldetag: 09.12.1993
(51) Int. Cl.: H03K 17/94

(54) **Opto-elektronische Tastatur**
Opto-electronic keyboard
Clavier à commande opto-électronique

(30) Priorität: 02.04.1993 EP 93105454
(43) Veröffentlichungstag der Anmeldung: 05.10.1994
(73) Patentinhaber: Endress + Hauser Flowtec AG, CH-4153 Reinach BL 1 (CH)
(72) Erfinder: Gillen, Thomas, Dr., D-79650 Schopfheim (DE); Brobeil, Wolfgang, Dipl.-Ing., D-79592 Fischingen (DE)
(74) Vertreter: Morstadt, Volker, Dipl.-Ing. c/o Endress + Hauser Flowtec AG

(56) Entgegenhaltungen:
- EP-A- 0 210 367
- CH-A- 676 177
- DE-A- 2 653 365
- US-A- 4 207 466

## Beschreibung

Die Erfindung betrifft eine fingerbetätigte, in industriellen Meßgeräten zu verwendende opto-elektronische Tastatur mit mindestens zwei Infrarot-Lichtsendern, mindestens zwei Infrarot-Lichtempfängern und einer Abdeckung.

In der CH-A 676 177 ist eine opto-elektronische, fingerbetätigte Tastatur beschrieben,
- die hinter einer mit Zeichenfeldern versehenen Verbundglasscheibe eines Schaufensters oder eines Bankschalters angeordnet ist,
- mit Tasten zur Erzeugung von jeweils einem zugehörigen Betätigungsnutzsignal,
- mit einem pro Taste an der Innenseite der Verbundglasscheibe angeordneten und gegen diese Innenseite praktisch senkrecht und mittels einer Blende eng gebündelt strahlenden Infrarot-Lichtsender und
- mit einem neben jedem Infrarot-Lichtsender angeordneten, zur Verbundglasscheibe hin ausgerichteten Infrarot-Lichtempfänger,
   -- der innerhalb des Hauptstrahlungsbereichs des vom zugehörigen Infrarot-Lichtsender ausgestrahlten und an einem Finger diffus gestreuten Infrarot-Lichtes, jedoch außerhalb des von der Außenseite und/oder von der Innenseite der Verbundglasscheibe reflektierten Infrarot-Lichtes liegt, und
- mit einer Betriebsschaltung, die umfaßt:
   -- für jeden Infrarot-Lichtsender eine eigene Detektionsschaltung aus einem Verstärker mit nachgeschaltetem Schwellwertschalter,
      --- der ein Binärsignal abgibt, dessen einer Pegel der Nichtbetätigung durch den Finger zugeordnet ist und dessen anderer Pegel bei Betätigung auftritt, und
   -- einen Generator für Stromimpulse mit einem Puls-Pausen-Verhältnis kleiner 1:1 zur Speisung der Infrarot-Lichtsender
      --- wobei die Frequenzen der Stromimpulse in derselben Größenordnung liegen.

Aus der EP-A 210 367 ist ferner eine Einrichtung zur Ansteuerung von Optokopplern mit jeweils einem Infrarot-Lichtsender und einem Infrarot-Lichtempfänger bekannt, wobei zum Infrarot-Lichtsender ein mikroprozessor-gesteuerter Schalter in Serie liegt, der nur dann geschlossen wird, wenn das Programm eine Auswertung des am Infrarot-Lichtempfänger auftretenden Signals erfordert, und wobei diese Auswertung gegenüber dem Schließen des Schalters um die Einschwingzeit des Optokopplers verzögert ist.

Die vorbeschriebene Tastatur erreicht zwar durch die räumliche Anordnung von Infrarot-Lichtsender und -Lichtempfänger einen eher guten Signal/Störabstand, zieht aber eine wesentliche und sich nach längerem Betrieb immer nachteiliger erweisende Eigenschaft von Infrarot-Lichtsendern nicht in Betracht, nämlich deren an sich bekannter, über längere Betriebszeiten hin auftretender Intensitätsabfall des gesendeten Infrarot-Lichtes bei gleicher Stromstärke. Es ist in diesem Zusammenhang klar, daß eine Erhöhung der Sendeleistung des Infrarot-Lichtsenders den Langzeit-Signal/Störabstand nicht verbessern würde.

Wie eigene Untersuchungen ergeben haben, ist es zur Erzielung eines möglichst optimalen Signal/Störabstands erforderlich, zusätzlich zur möglichst optimalen räumlichen Anordnung von Infrarot-Lichtsender und -Lichtempfänger, die insb. bei dicken Abdeckungen wichtig ist, also wenn deren Dicke 2 mm bis 3 mm überschreiten soll, und wenn Infrarot-Lichtsender sowie -Lichtempfänger für eine kompakte Bauweise nahe beieinander angeordnet sein sollen, auch Maßnahmen schaltungstechnischer Art gegen den erwähnten Intensitätsabfall zu ergreifen.

Ferner bedingt eine dicke Abdeckung, wie sie, um den verschiedenen Explosionsschutzklassen für industrielle Meßgeräte zu genügen, erforderlich wird, eine große Entfernung zwischen dem Finger und dem Infrarot-Lichtempfänger, so daß der an ihm auftretende Signalpegel gegenüber einer dünnen Abdeckung verringert ist. Auch bei diesen dicken Abddeckungen würde eine Erhöhung der Sendeleistung des Infrarot-Lichtsenders den Signal/Störabstand nicht verbessern.

Die in den Ansprüchen definierte Erfindung dient der Erreichung dieser Ziele auf möglichst optimale Weise. Es muß also zunächst durch eine optimale gegenseitige Anordnung der Störsignalpegel am Infrarot-Lichtempfänger verringert und zugleich dessen Nutzsignalpegel möglichst groß gemacht werden, und es muß zugleich der während der Betriebsdauer der Infrarot-Lichtsender auftretende Intensitätsabfall des gesendeten Infrarot-Lichtes durch schaltungstechnische Maßnahmen unter Berücksichtigung der Bedienbarkeit, also der ausreichend schnellen und sicheren "Erkennung" einer Fingerbetätigung, verringert werden, so daß die anfängliche Intensität möglichst lange sichergestellt bleibt.

Hierzu besteht die Erfindung in einer in industriellen Meßgeräten zu verwendenden opto-elektronischen, fingerbetätigten Tastatur
- mit mindestens zwei Tasten zur Erzeugung von jeweils einem zugehörigen Betätigungsnutzsignal,
- mit einer infrarotlicht-durchlässigen Abdeckung,
- mit einem pro Taste an der Innenseite der Abdeckung angeordneten und gegen diese Innenseite praktisch senkrecht und eng gebündelt strahlenden Infrarot-Lichtsender,
   -- wobei die Infrarot-Lichtsender in einem zur Einzelbetätigung ausreichenden Mindestabstand nebeneinander angeordnet sind,
- mit einem neben jedem Infrarot-Lichtsender und von diesem durch jeweils eine infrarotlicht-undurchlässige Abschirmung getrennt angeordneten, zur Abdeckung hin ausgerichteten Infrarot-Lichtempfänger,
   -- der innerhalb des Hauptstrahlungsbereichs des vom zugehörigen Infrarot-Lichtsender ausgestrahlten und an einem Finger diffus gestreuten Infrarot-Lichtes, jedoch außerhalb des von der Außenseite und/oder von der Innenseite der Abdeckung reflektierten Infrarot-Lichtes liegt, und
- mit einer Betriebsschaltung, die umfaßt:
   -- für jede Taste eine eigene Steuer- und Detektionsschaltung,
      --- die zur Speisung des jeweiligen Infrarot-Lichtsenders Stromsteuerimpulse mit einem Puls-Pausen-Verhältnis kleiner 1:1 erzeugt,
         ---- wobei die Frequenzen der Stromsteuerimpulse der einzelnen Steuer- und Detektionsschaltungen in derselben Größenordnung liegen,
      --- die ferner ein Binärsignal abgibt, dessen einer Pegel der Nichtbetätigung durch den Finger zugeordnet ist und dessen anderer Pegel bei Betätigung erst nach einer Detektionszeit auftritt,
   -- und für alle Tasten eine gemeinsame Abfrageschaltung,
      --- die periodische Zeitfensterimpulse erzeugt,
         ---- deren Puls-Pausen-Verhältnis kleiner als 1:1 ist,
         ---- deren Dauer größer als die Detektionszeit ist,
         ---- die einen alle Steuer- und Detektionsschaltungen mit einem Pol einer Betriebsspannungsquelle verbindenden Stromschalter leitend steuern, und
      --- die ein mit den Zeitfensterimpulsen gleichfrequentes Abtastsignal erzeugt,
         ---- mit dem aus einem innerhalb jedes Zeitfensterimpulses nach der Detektionszeit vorhandenen Signalpegel des jeweiligen Binärsignals das jeweilige Betätigungsnutzsignal gebildet wird.

Nach einer bevorzugten Ausführungsform der Erfindung beträgt das Puls-Pausen-Verhältnis des Zeitfensterimpulses höchstens 1:10. Nach einer anderen bevorzugten Ausführungsform der Erfindung beträgt das Puls-Pausen-Verhältnis der Stromimpulse ebenfalls höchstens 1:10. Nach einer weiteren bevorzugten Ausführungsform der Erfindung hat die Tastatur drei Tasten.

Die Erfindung hat u.a. die Vorteile:
- Eine gegenüber der vorbeschriebenen Anordnung weitere Verbesserung des Signal/Störabstands ergibt sich durch die Abschirmung zwischen Infrarot-Lichtsender und -Lichtempfänger.
- Eine Reflexion an der Außenseite der Abdeckung betätigt die Tastatur nicht. Daher kann eine Betauung oder Verschmutzung der Außenseite zugelassen werden, was bei der vorbeschriebenen Anordnung zu Fehlbetätigungen führen würde.
- Die Dicke der Abdeckung kann insb. auch so gewählt werden, daß die verschiedenen Explosionsschutzart-Vorschriften eingehalten werden können; die glasartige Abdeckung kann daher 5 mm dick, insb. aber auch dicker sein.
- Aufgrund der senkrechten Anordnung des Infrarot-Lichtsenders und aufgrund der Abschirmung kann der Infrarot-Lichtempfänger wesentlich näher beim Lichtsender angeordnet werden, als dies bei der vorbeschriebenen Anordnung möglich ist, so daß die Infrarot-Lichtsender in dem zur Einzelbetätigung gerade noch ausreichenden Mindestabstand nebeneinander angeordnet sein können.
- Es können daher kompakte Tastaturen aufgebaut werden.
- Der Intensitätsabfall des von den Infrarot-Lichtsendern gesendeten Infrarot-Lichtes ist so reduziert, daß übliche Infrarot-Lichtsender während der Gebrauchsdauer des industriellen Meßgeräts nicht ersetzt zu werden brauchen.

Die Erfindung wird nun anhand von in den Figuren der Zeichnung dargestellten Ausführungsbeispielen näher erläutert.
- Fig. 1: zeigt schematisch das der Erfindung zugrundeliegende Prinzip hinsichtlich der Anordnung von Infrarot-Lichtsender und -Lichtempfänger,
- Fig. 2: zeigt in Draufsicht, in Unteransicht und in zwei Schnittansichten eine Halterung für die Infrarot-Lichtsender und die Infrarot-Lichtempfänger einer opto-elektronischen Dreifach-Tastatur nach der Erfindung,
- Fig. 3: zeigt schematisch ein Blockschaltbild einer Betriebschaltung,
- Fig. 4: zeigt schematisch ein Blockschaltbild einer in der Betriebschaltung nach Fig. 3 enthaltenen Abfrageschaltung,
- Fig. 5: zeigt verschiedene Impulsdiagramme von in der Betriebschaltung nach Fig. 3 auftretenden Signalen, und
- Fig. 6: zeigt einige der Impulsdiagramme der Fig. 5 in demgegenüber zeitlich komprimiertem Maßstab zusammen mit einem weiteren Impulsdiagramm.

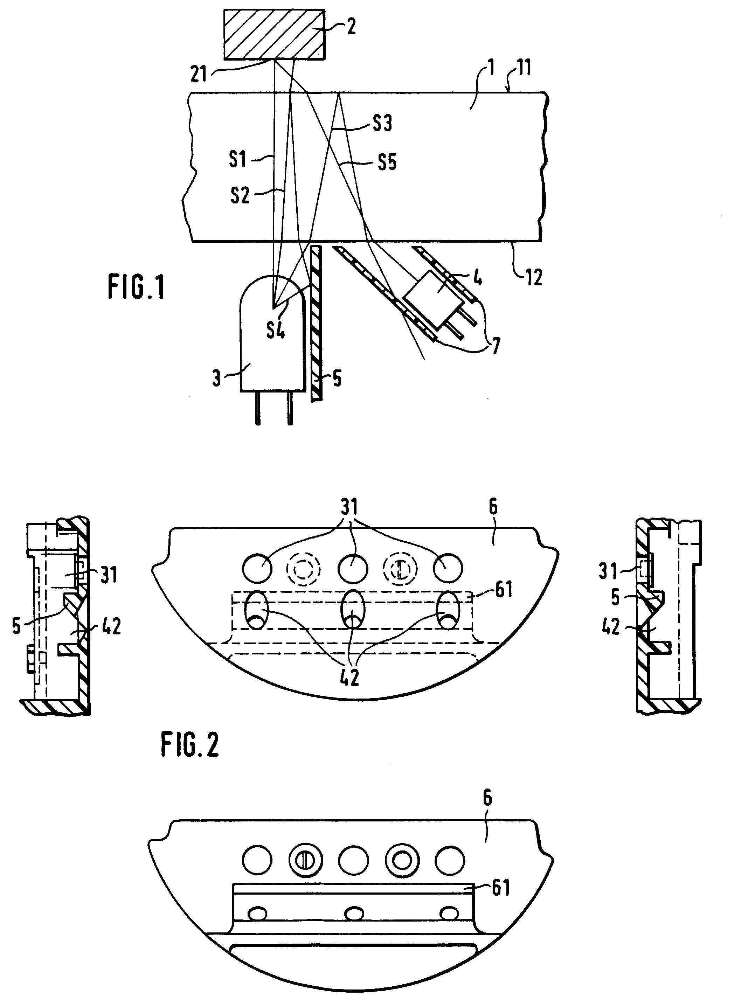

In Fig. 1 ist stark schematisiert das dem mechanischen Teil der Erfindung zugrunde liegende Lösungsprinzip gezeigt. Die wesentlichen Bestandteile der opto-elektronischen Tastatur sind eine infrarotlicht-durchlässige Abdeckung 1, ein Infrarot-Lichtsender 3, ein Infrarot-Lichtempfänger 4 und eine infrarotlicht-undurchlässige Abschirmung 5. Für die Funktion dieser opto-elektronischen Tastatur ist ferner noch ein in die Nähe der Außenseite 11 der Abdeckung 1 bringbarer und die opto-elektronische Tastatur betätigender Finger 2 als Streukörper nötig.

Infrarot-Lichtsender 3, Infrarot-Lichtempfänger 4 und Abschirmung 5 sind an der Innenseite 12 der Abdeckung 1 angeordnet, deren Dicke in Fig. 1 aus Gründen der besseren Anschaulichkeit nicht maßstabsgerecht gezeichnet ist. Die Strahlungsrichtung des Infrarot-Lichtsenders 3 ist praktisch senkrecht zur Innenseite 12 der Abdeckung 1 oder weicht nur wenig von dieser Senkrechten ab. Die Strahlung ist dabei um diese Richtung eng gebündelt.

Die optische Achse des Infrarot-Lichtempfängers 4 ist unter Berücksichtigung der Brechung an und in der Abdeckung 1 auf das Streuzentrum 21 des Fingers 2 ausgerichtet. Als Streuzentrum 21 ist der Schnittpunkt der optischen Achsen des Infrarot-Lichtsenders 3 und des Infrarot-Lichtempfängers 4, jeweils unter Berücksichtigung der Lichtbrechung durch die Abdeckung 1, definiert. Für exakt senkrechte Ausrichtung des Infrarot-Lichtsenders 3 auf die Abdeckung 1 braucht bei dieser konstruktiven Bemessung natürlich nur die Brechung des am Finger 2 gestreuten Lichtes berücksichtigt zu werden.

Durch eine Blende und/oder eine abschirmungsartige Lichtführung 7 kann erreicht werden, daß nur Infrarot-Licht aus der nahen Umgebung des Fingers 21 zum Infrarot-Lichtempfänger 4 gelangt.

Der Infrarot-Lichtempfänger 4 ist neben dem Infrarot-Lichtsender 3 angeordnet und von diesem durch die infrarotlicht-undurchlässige Abschirmung 5 getrennt. Der Infrarot-Lichtempfänger 4 liegt innerhalb des Hauptstrahlungsbereichs des vom Infrarot-Lichtsender 3 zum Finger 2 ausgestrahlten und am Finger diffus gestreuten Infrarot-Lichtes, jedoch außerhalb des von der Außenseite und/oder von der Innenseite der Abdeckung 1 reflektierten Infrarot-Lichtes.

Dies ist in Fig. 1 veranschaulicht: Der Strahl S3 des vom Infrarot-Lichtsender 3 emittierten Infrarot-Lichtes, der die Abschirmung 5 gerade noch passieren kann, gelangt nach der Reflexion an der Innenseite 12 und/oder an der Außenseite 11 der Abdeckung 1 nicht zum Infrarot-Lichtempfänger 4 und kann somit dort kein Störsignal hervorrufen. Dies gilt auch für alle Strahlen, die unter - bezogen auf den Hauptstrahl S1 - kleineren Winkeln als der des Strahls S3 abgestrahlt werden, wie z.B. der Strahl S2.

Wie ferner der Strahl S4 zeigt, können infolge der Abschirmung 5 alle unter großen Winkeln aus dem Infrarot-Lichtsender 3 austretenden Strahlen erst gar nicht zur Abdeckung 1 gelangen. Der praktisch senkrecht zur Abdeckung 1 emittierte Hauptanteil des Infrarot-Lichtes trifft auf den Finger 2 im Bereich von dessen Streuzentrum 21 und gelangt als Streustrahlung S5 zum infrarotlicht-empfindlichen Teil des Infrarot-Lichtempfängers 4. Diese Streustrahlung ist das optische Nutzsignal.

Das Störsignal geht hauptsächlich auf Strahlungsanteile zurück, die durch Streuung im und Mehrfachreflexionen am Material der Abdeckung 1 entstehen. Die Intensität des Störsignals ist kleiner als bei Anordnungen nach dem obigen Stand der Technik, insb. aber wesentlich kleiner als bei Anordnungen mit gleichem Ein- und Ausfallswinkel der optischen Achsen von Infrarot-Lichtsender und Infrarot-Lichtempfänger.

In Fig. 2 ist in Draufsicht (oben Mitte), in Unteransicht (unten) und in linker sowie in rechter Schnittansicht (Symmetrielinie der Draufsicht als Schnittlinie) eine Halterung 6 für die Infrarot-Lichtsender, Infrarot-Lichtempfänger und Abschirmungen einer Dreifachtastatur gezeigt. Die Halterung 6 ist bevorzugt ein Kunststoffteil, an das die Abschirmungen als gemeinsamer Steg 61 angeformt sind.

In Fig. 2 sind die Infrarot-Lichtsender und die Infrarot-Lichtempfänger nicht in die Halterung 6 eingesetzt, so daß deren Aufnahmen 31 (für die Infrarot-Lichtsender) bzw. 42 (für die Infrarot-Lichtempfänger) besser erkennbar sind. In Fig. 2 ist die Abdeckung 1, die auf die in der Draufsicht nicht darstellbare ebene Oberseite der Halterung 6 aufgelegt und mit ihr, z.B. an deren Rand, befestigt, z.B. verschraubt, insb. explosionsschutz-dicht befestigt, wird, ebenfalls weggelassen.

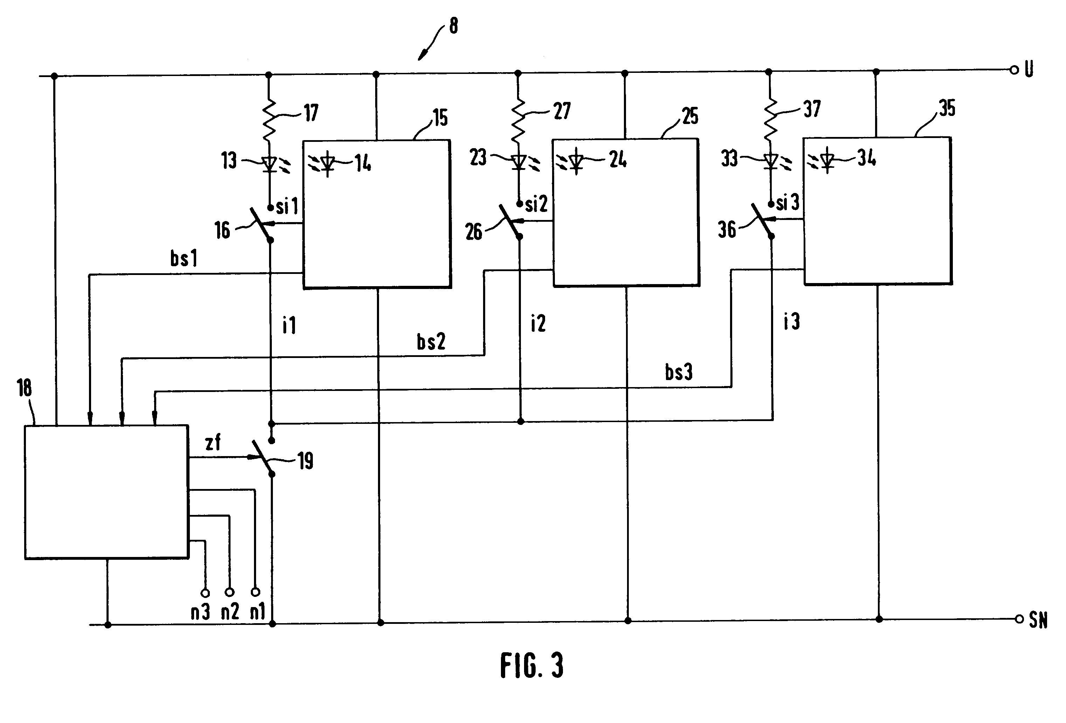

In Fig. 3 ist in Form eines schematisierten Blockschaltbilds das dem schaltungstechnischen Teil der Erfindung zugrunde liegende Lösungsprinzip anhand einer Betriebsschaltung 8 für eine Dreifachtastatur gezeigt.

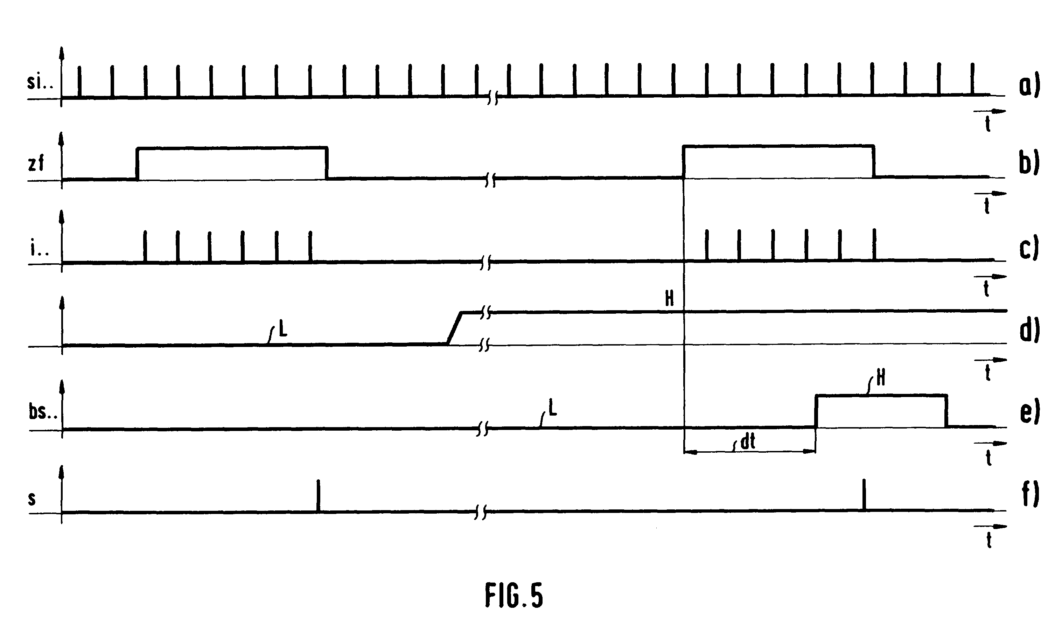

Die Betriebsschaltung 8 von Fig. 3 enthält für jede der drei opto-elektronischen Tasten mit den jeweiligen Infrarot-Lichtsendern/-Lichtempfängern 13/14, 23/24, 33/34 eine eigene Steuer- und Detektionsschaltung 15, 25, 35. Diese erzeugen zur Speisung des jeweiligen Infrarot-Lichtsenders erforderliche Stromsteuerimpulse si1, si2, si3 (vgl. Fig. 5a) mit einem Puls-Pausen-Verhältnis kleiner 1:1, bevorzugt kleiner 1:10.

Die Stromsteuerimpulse si1, si2, si3 sind nach Fig. 3 an den Steuereingang eines jeweiligen elektronischen Schalters 16, 26, 36 gelegt, der zum jeweiligen Infrarot-Lichtsender 13, 23, 33 in Serie liegt, der seinerseits über einen üblichen Strombegrenzungswiderstand 17, 27, 37 mit einem spannungsführenden Pol U einer Betriebsspannungsquelle verbunden ist.

Die Frequenzen der Stromsteuerimpulse si1, si2, si3 der einzelnen Steuer- und Detektionschaltungen 15, 25, 35 liegen in derselben Größenordnung, z.B. zwischen 5 kHz und 15 kHz. Mit anderen Worten ist es also nicht erforderlich, daß die Stromsteuerimpulse si1, si2, si3 dieselbe Frequenz haben müssen; somit können entsprechende Maßnahmen entfallen..

Die Steuer- und Detektionsschaltungen 15, 25, 35 erzeugen ferner jeweils ein Binärsignal bs1, bs2, bs3 (vgl. Fig. 5e), dessen jeweiliger einer Pegel L der Nichtbetätigung durch den Finger 2 zugeordnet ist und dessen jeweiliger anderer Pegel H bei Betätigung erst nach einer Detektionszeit dt (vgl. Fig. 5) auftritt.

Als Steuer- und Detektionsschaltungen 15, 25, 35 mit deren eben beschriebener Funktion können sogenannte OPICs (Light Detector with Built-in Signal Processing Circuit for Light Modulation System) der Firma Sharp mit der Typenbezeichnung IS471F, also handelsübliche opto-elektronische Bauelemente, verwendet werden; das entsprechende Datenblatt ist als Anhang beigefügt, worin u.a. auch die oben genannte Detektionszeit dt als "Response time" erwähnt ist.

Die OPICs sind den jeweiligen Infrarot-Lichtempfänger 14, 24, 34 umfassende integrierte Halbleiterschaltungen. Aus diesem Grund sind in Fig. 3 diese Infrarot-Lichtempfänger auch innerhalb des Schaltungsblocks der Steuer- und Detektionsschaltungen 15, 25, 35 gezeichnet.

Die Betriebsschaltung 8 nach Fig. 3 enthält auch eine allen opto-elektronischen Tasten gemeinsame Abfrageschaltung 18, die periodische Zeitfensterimpulse zf (vgl. Fig. 5b) erzeugt. Deren Puls-Pausen-Verhältnis ist kleiner als 1:1, bevorzugt kleiner 1:10, und deren Dauer ist größer als die Detektionszeit dt.

Die Zeitfensterimpulse zf steuern einen Stromschalter 19, der somit periodisch leitend bzw. nichtleitend wird. Nur in seinem leitenden Zustand schließt er den Stromkreis aller Infrarot-Lichtsender 13, 23, 33, so daß sich dieser leitende Zustand dem von den Stromsteuerimpulsen si.. bedingten periodischen leitenden Zustand des jeweiligen elektronischen Schalters 16, 26, 36 im Sinne einer UND-Verknüpfung überlagert.

Die einzelnen Infrarot-Lichtsender 13, 23, 33 werden somit nur von den Stromimpulsen i1, i2, i3 durchflossen (vgl. Fig. 5c). Somit ist die Strombelastung der Infrarot-Lichtsender gegenüber dem vorbeschriebenen Dauer-Schaltbetrieb sehr stark reduziert, was praktisch die Vermeidung des oben erwähnten Intensitätsabfalls ermöglicht.

Die Abfrageschaltung 18 erzeugt ferner ein mit den Zeitfensterimpulsen zf gleichfrequentes Abtastsignal s (vgl. Fig. 5f), mit dem aus einem innerhalb jedes Zeitfensterimpulses zf nach der Detektionszeit dt vorhandenen Signalpegel H bzw. L des Binärsignals bs.. das jeweilige Betätigungsnutzsignal n1, n2, n3 gebildet wird.

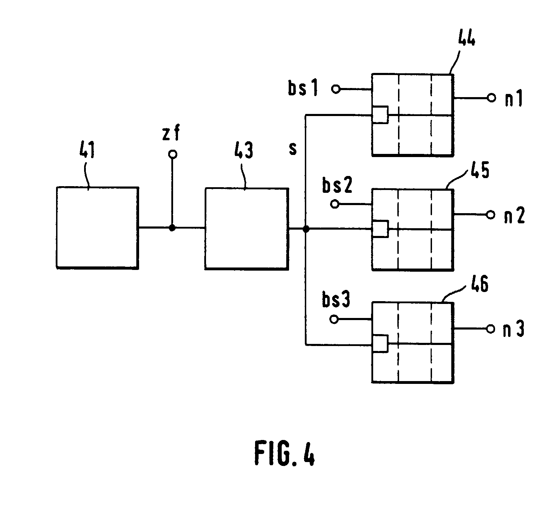

Hierzu dient vorzugsweise der in Fig. 4 als Blockschaltbild gezeigte Aufbau der Abfrageschaltung nach Fig. 3. Ein Rechteckoszillator 41 erzeugt die Zeitfensterimpulse zf, die - außer der erwähnten Steuerung des elektronischen Schal-ters 19 zu dienen - auch einer Verzögerungsschaltung 43 zugeführt sind, deren Verzögerungszeit etwas kleiner als die Dauer des Zeitfensterimpulses zf, aber größer als die Detektionszeit dt ist. Am Ausgang der Verzögerungsschaltung 43 wird ein kurzer, praktisch nadelförmiger Abtastsignalimpuls s abgegeben.

In der Abfrageschaltung nach Fig. 4 sind ferner drei D-Flipflops 44, 45, 46 vorhanden, deren jeweiligem Takteingang das Abtastsignal s und deren jeweiligem D-Eingang das jeweilige Binärsignal bs1, bs2, bs3 zugeführt ist. Am jeweiligen Q-Ausgang entsteht dann das jeweilige Betätigungsnutzsignal n1, n2, n3.

Die Funktion der Abfrageschaltung kann nicht nur auf die in Fig. 4 gezeigte Weise, sondern auch bei Bedarf mittels eines aus anderen Gründen im industriellen Meßgerät schon vorhandenen Mikroprozessors realisiert werden.

Zu den bereits erwähnten Teilfiguren der Fig. 5, in der die einzelnen Signale über der Zeit t aufgetragen sind, ist noch anzumerken, daß sie aus Gründen der zeichnerischen Darstellbarkeit ohne Rücksicht auf die oben erläuterten Zeitbeziehungen der einzelnen Signale untereinander gezeichnet sind und daß Fig. 5d ein einer Betätigung durch einen Finger entsprechendes virtuelles Signal zeigt.

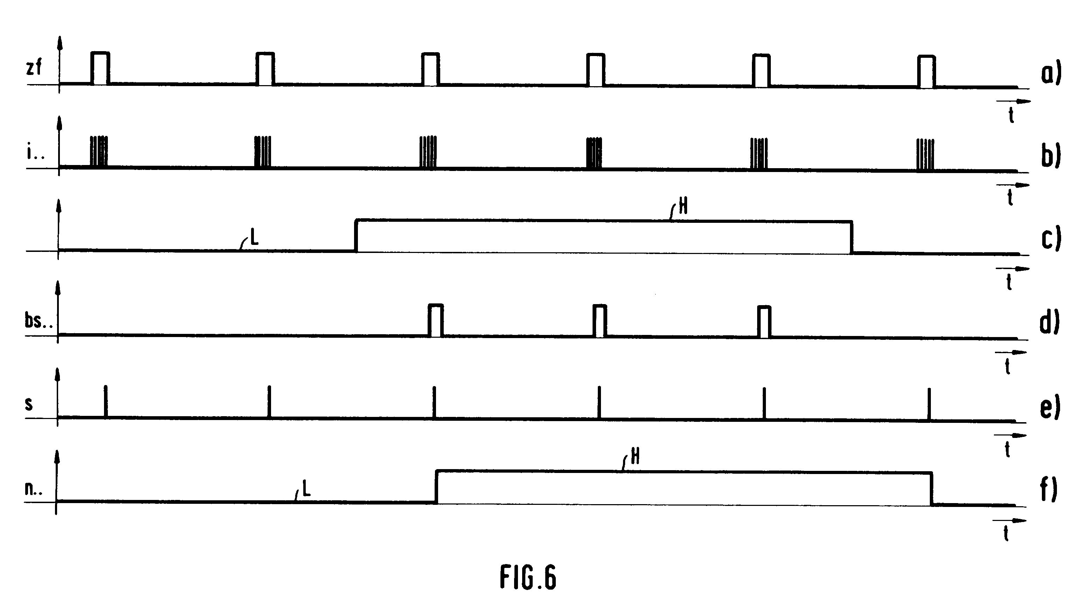

In Fig. 6 ist der Zeitmaßstab gegenüber Fig. 5 komprimiert, und es fehlt eine der Fig. 5a entsprechende Teilfigur mit den Stromsteuerimpulsen si.., da diese innerhalb der Zeichenstrichstärke liegen würden.

Fig. 6a zeigt die Zeitfensterimpulse zf und Fig. 6b die Stromimpulse i.. in einem der Infrarot-Lichtsender 13, 23, 33. Fig. 6c zeigt wiederum eines der der Betätigung entsprechenden virtuellen Signale und Fig. 6d eines der Binärsignale bs.. In Fig. 6e ist das Abtastsignal s zu sehen und in Fig. 6f eines der Betätigungsnutzsignale n.. Aus den Fig. 6c und 6f geht hervor, daß das Betätigungsnutzsignal n.. solange dauert, wie der Finger 2 eine der opto-elektronischen Tasten betätigt.

Durch die Betriebsschaltung nach der Erfindung wird der bereits mehrmals erwähnte Intensitätsabfall, der von der während der Strahlungsabgabe durch den Lichtsender geflossenen Ladung, also dem Strom-Zeit-Produkt, abhängig ist, dadurch in weite zeitliche Ferne gerückt, daß in momentan weiten Zeitabständen einige wenige kurze Stromimpulse lediglich während der Zeitfensterimpulse, also nur während der Auswertungszeit einer Betätigung, durch die Lichtsender geschickt werden. Somit kann auf eine aufwendige, an sich bekannte Intensitätsregelung verzichtet werden.

In einem konkret realisierten Meßgerät hatten, wie oben schon erwähnt wurde, die Stromsteuerimpulse si.. eine für die erwähnten Bausteine IS471F typische Frequenz zwischen 5 kHz und 15 kHz, waren also unter einander nicht gleichfrequent, und hatten ein Puls-Pausen-Verhältnis von 1:15. Die Zeitfensterimpulse zf hatten eine Frequenz von ca. 10 Hz und ein Puls-Pausen-Verhältnis von ca. 1:50. Die Dauer der Zeitfensterimpulse zf betrug somit ca. 2 ms, was größer ist als der für die erwähnten Bausteine IS471F angegebene maximalen Wertes der Detektionszeit dt von 670 µs. Für den Faktor Zeit im obigen Strom-Zeit-Produkt ergibt sich somit eine Verlängerung um das etwa Fünfzigfache.

Das Puls-Pausen-Verhältnis der Zeitfensterimpulse kann unter Berücksichtigung der beanspruchten Bemessung in der Weise unterschiedlich gemacht werden, daß es während der Betätigung der Tastatur größer als bei deren Nichtbetätigung ist. Dadurch kann der Faktor Zeit im obigen Strom-Zeit-Produkt noch weiter vergrößert werden. Dies kann z.B. durch eine zusätzliche Tastenabfrage erreicht werden.

Eine unter Verwendung der Halterung nach Fig. 2 gebildete Tastatur ist in industriellen Meßgeräten zu verwenden bzw. einzusetzen, z.B. in Durchfluß-, in Füllstands- oder in Analysemeßgeräten, und kann durch Wahl der Dicke der Abdeckung 1 ohne weiteres an die breite Palette der Explosionsschutz-Vorschriften angepaßt werden. In diesen Geräten dient die Tastatur zur Eingabe von Signalen, mit denen Bereiche von Geräteparametern, vorzugsweise computerunterstützt, ausgewählt, eingestellt, abgeglichen oder verändert werden können. Aufgrund der "doppelten Stromreduzierung" in den Infrarot-Lichtsendern ist während der gesamten Betriebsdauer dieser Meßgeräte kein nennenswerter Intensitätsabfall zu erwarten.

## Patentansprüche

1. In industriellen Meßgeräten zu verwendende opto-elektronische, finger-betätigte Tastatur
- mit mindestens zwei Tasten zur Erzeugung von jeweils einem zugehörigen Betätigungsnutzsignal (n1, n2, n3),
- mit einer infrarotlicht-durchlässigen Abdeckung (1),
- mit einem pro Taste an der Innenseite (12) der Abdeckung angeordneten und gegen diese Innenseite praktisch senkrecht und eng gebündelt strahlenden Infrarot-Lichtsender (3),
-- wobei die Infrarot-Lichtsender in einem zur Einzelbetätigung ausreichenden Mindestabstand nebeneinander angeordnet sind,
- mit einem neben jedem Infrarot-Lichtsender und von diesem durch jeweils eine infrarotlicht-undurchlässige Abschirmung (5) getrennt angeordneten, zur Abdeckung hin ausgerichteten Infrarot-Lichtempfänger (4),
-- der innerhalb des Hauptstrahlungsbereichs des vom zugehörigen Infrarot-Lichtsender ausgestrahlten und an einem Finger (2) diffus gestreuten Infrarot-Lichtes, jedoch außerhalb des von der Außenseite und/oder von der Innenseite der Abdeckung reflektierten Infrarot-Lichtes liegt, und
- mit einer Betriebsschaltung (8) die umfaßt:
-- für jeden Infrarot-Lichtsender (13, 23, 33) einen dazu in Serie liegenden elektronischen Schalter (16, 26, 36),
-- für jede Taste eine eigene Steuer- und Detektionsschaltung (15, 25, 35),
--- die zur Steuerung des jeweiligen elektronischen Schalters und somit zur Speisung des jeweiligen Infrarot-Lichtsenders (13, 23, 33) jeweils Stromsteuerimpulse (si1, si2, si3) mit einem Puls-Pausen-Verhältnis kleiner 1:1 erzeugt,
---- wobei die Frequenzen der Stromsteuerimpulse der einzelnen Steuer- und Detektionsschaltungen in derselben Größenordnung liegen,
--- die ferner ein Binärsignal (bs1, bs2, bs3) abgibt, dessen einer Pegel (L) der Nichtbetätigung durch den Finger (2) zugeordnet ist und dessen anderer Pegel (H) bei Betätigung erst nach einer Detektionszeit (dt) auftritt,
-- und für alle Tasten eine gemeinsame Abfrageschaltung (18),
--- die periodische Zeitfensterimpulse (zf) erzeugt,
---- deren Puls-Pausen-Verhältnis kleiner als 1:1 ist,
---- deren Dauer größer als die Detektionszeit (dt) ist und
---- die einen alle elektronischen Schalter (16, 26, 36) mit einem Pol (SN) einer Betriebsspannungsquelle verbindenden Stromschalter (19) leitend steuern, und
--- die ein mit den Zeitfensterimpulsen (zf) gleichfrequentes Abtastsignal (s) erzeugt,
---- mit dem aus einem innerhalb jedes Zeitfensterimpulses (zf) nach der Detektionszeit (dt) vorhandenen Signalpegel (H, L) des jeweiligen Binärsignals (bs1, bs2, bs3) das jeweilige Betätigungsnutzsignal (n1, n2, n3) gebildet wird.

2. Opto-elektronische, finger-betätigte Tastatur nach Anspruch 1 mit einem Puls-Pausen-Verhältnis der Zeitfensterimpulse (zf) von höchstens 1:10.

3. Opto-elektronische, finger-betätigte Tastatur nach Anspruch 1 mit einem Puls-Pausen-Verhältnis der Stromsteuerimpulse (si..) von höchstens 1:10.

4. Opto-elektronische, finger-betätigte Tastatur nach Anspruch 1 mit drei Tasten.

## Claims

1. An optoelectronic, finger-operated keyboard for use in industrial measurement equipment, comprising
- at least two keys for generating one associated operation signal (n1, n2, n3) each,
- an infrared-transmitting cover (1),
- one infrared emitter (3) per key which is disposed at the inside (12) of the cover and emits infrared light collimated virtually perpendicular to said inside,
-- the infrared emitters being arranged side by side with a minimum spacing sufficient for individual operation,
- one infrared detector (4) adjacent to each infrared emitter which is separated from the latter by a shield (5) opaque to infrared, and which is pointed at the cover,
-- said infrared detector (4) being located within the main radiation range of the infrared light emitted by the associated infrared emitter and diffusely scattered at a finger (2), but outside the infrared light reflected from the outside and/or inside of the cover, and
- an operating circuit (8) comprising:
-- a respective electronic switch (16, 26, 36) for and in series with each infrared emitter (13, 23, 33),
-- a separate control and detection circuit (15, 25, 35) for each key
--- which generates current control pulses (si1, si2, si3) with a mark/space ratio less than 1:1 for controlling the respective electronic switch and thus for feeding the respective infrared emitter (13, 23, 33),
---- the frequencies of the current control pulses of the individual control and detection circuits being of the same order of magnitude,
--- the control and detection circuit (15, 25, 35) further providing a binary signal (bs1, bs2, bs3) one level (L) of which is assigned to nonoperation by the finger (2) and the other level (H) of which occurs after a detection time (dt) following an operation, and
-- a scanning circuit (18) common to all keys
--- which generates periodic time-window pulses (zf)
---- whose mark/space ratio is less than 1:1,
---- whose duration is longer than the detection time (dt), and
---- which switch a current switch (19) connecting all control and detection circuits (15, 25, 35) to one terminal (SN) of a supply-voltage source into a conducting state,
--- said scanning circuit (18) generating a sampling signal (s) which is equal in frequency to the time-window pulses (zf), and
---- with which the respective operation signal (n1, n2, n3) is formed from a level (H, L) of the respective binary signal (bs1, bs2, bs3) which is present within each time-window pulse (zf) after the detection time (dt).

2. An optoelectronic, finger-operated keyboard as claimed in claim 1, with a mark/space ratio of the time-window pulses (zf) of 1:10 at the most.

3. An optoelectronic, finger-operated keyboard as claimed in claim 1, with a mark/space ratio of the current control pulses (si..) of 1:10 at the most.

4. An optoelectronic, finger-operated keyboard as claimed in claim 1, with three keys.

## Revendications

1. Clavier optoélectronique commandé avec les doigts, à utiliser dans des appareils de mesure industriels comprenant
- au moins deux touches produisant respectivement un signal utile correspondant de déclenchement (n1, n2, n3),
- un cache (1) laissant passer la lumière infrarouge,
- un émetteur (3) de lumière infrarouge par touche, disposé sur le côté intérieur (12) du cache et rayonnant contre ce côté intérieur pratiquement verticalement et en faisceau étroit;
-- les émetteurs de lumière infrarouge étant disposés l'un à côté de l'autre suivant un intervalle minimum suffisant pour être commandés individuellement,
- un récepteur (4) de lumière infrarouge, aligné par rapport au cache, disposé à côté de chacun des émetteurs de lumière infrarouge et séparé respectivement de chacun d'eux par un écran (5) ne laissant pas passer la lumière infrarouge,
-- qui se trouve à l'intérieur de la zone de rayonnement principal de lumière infrarouge émise par l'émetteur correspondant de lumière infrarouge et diffusée par la commande du doigt (2), se trouvant cependant à l'extérieur de la lumière infrarouge réfléchie par le côté extérieur et/ou par le côté intérieur du cache, et
- un circuit de fonctionnement (8) qui comprend :
-- un interrupteur électronique (16, 26, 36) monté en série avec chacun des émetteurs de lumière infrarouge (13, 23, 33),
-- un circuit de commande et de détection (15, 25, 35) propre à chaque touche,
--- qui produit respectivement des impulsions de commande du courant (si1, si2, si3), avec un rapport impulsons/pauses inférieur à 1:1, pour commander l'interrupteur électronique correspondant et donc pour alimenter l'émetteur correspondant de lumière infrarouge (13, 23, 33);
---- les fréquences des impulsions de commande du courant des différents circuits de commande et de détection étant du même ordre de grandeur,
--- un circuit de commande et de détection qui fournit en outre un signal binaire (bs1, bs2, bs3) dont un niveau (L) de non déclenchement est donné par le doigt (2) et dont l'autre niveau (H) n'apparaît lors du déclenchement qu'après un temps de détection (dt),
-- et un circuit commun d'interrogation (18) pour toutes les touches,
--- qui produit des impulsions périodiques formant des fenêtres temporelles (zf),
---- dont le rapport impulsions/pauses est inférieur à 1:1,
---- dont la durée est supérieure au temps de détection (dt) et
---- qui commandent de façon conductrice un interrupteur de courant (19) reliant tous les interrupteurs électroniques (16, 26, 36) à un pôle (SN) d'une source de tension de secteur, et
--- un circuit d'interrogation qui produit un signal de balayage (s) de même fréquence que les impulsions formant des fenêtres temporelles (zf),
---- avec lequel le signal utile correspondant de déclenchement (n1, n2, n3) est formé à partir d'un niveau de signal existant (H, L) du signal binaire correspondant (bs1, bs2, bs3), à l'intérieur de chaque impulsion formant une fenêtre temporelle (zf) après le temps de détection (dt).

2. Clavier optoélectronique commandé avec les doigts, selon la revendication 1, avec un rapport impulsions/ pauses des impulsions formant des fenêtres temporelles (zf) au maximum de 1:10.

3. Clavier optoélectronique commandé avec les doigts, selon la revendication 1, avec un rapport impulsions/ pauses des impulsions de commande- du courant (si ..) au maximum de 1:10.

4. Clavier optoélectronique commandé avec les doigts, selon la revendication 1, comportant trois touches.
